Europäisches Patentamt

European Patent Office

Office européen des brevets

(19)

(11) **EP 0 722 215 B1**

(12) **FASCICULE DE BREVET EUROPEEN**

(45) Date de publication et mention
de la délivrance du brevet:
**16.08.2001   Bulletin 2001/33**

(51) Int Cl.7: **H03D 3/24**

(21) Numéro de dépôt: **96410007.7**

(22) Date de dépôt: **10.01.1996**

(54) **PLL-FM demodulateur**

PLL-FM-Demodulator

PLL-FM demodulator

(84) Etats contractants désignés:
**DE FR GB IT**

(30) Priorité:  **13.01.1995  FR 9500603**

(43) Date de publication de la demande:
**17.07.1996   Bulletin 1996/29**

(73) Titulaire: **STMicroelectronics S.A.**
**94250 Gentilly (FR)**

(72) Inventeur: **Mellot, Pascal**
**F-38100 Grenoble (FR)**

(74) Mandataire: **de Beaumont, Michel**
**1bis, rue Champollion**
**38000 Grenoble (FR)**

(56) Documents cités:
**US-A- 3 909 735          US-A- 4 479 091**
**US-A- 4 816 770          US-A- 5 272 453**

## Description

La présente invention concerne l'accord d'une boucle à verrouillage de phase (PLL) et la démodulation d'une porteuse sonore modulée et s'applique en particulier à la démodulation d'un son modulé en fréquence (FM) dans un récepteur de télévision. Dans un tel système, une pluralité de fréquences porteuses s'étendent typiquement sur la plage de 4,5 à 6,5 MHz.

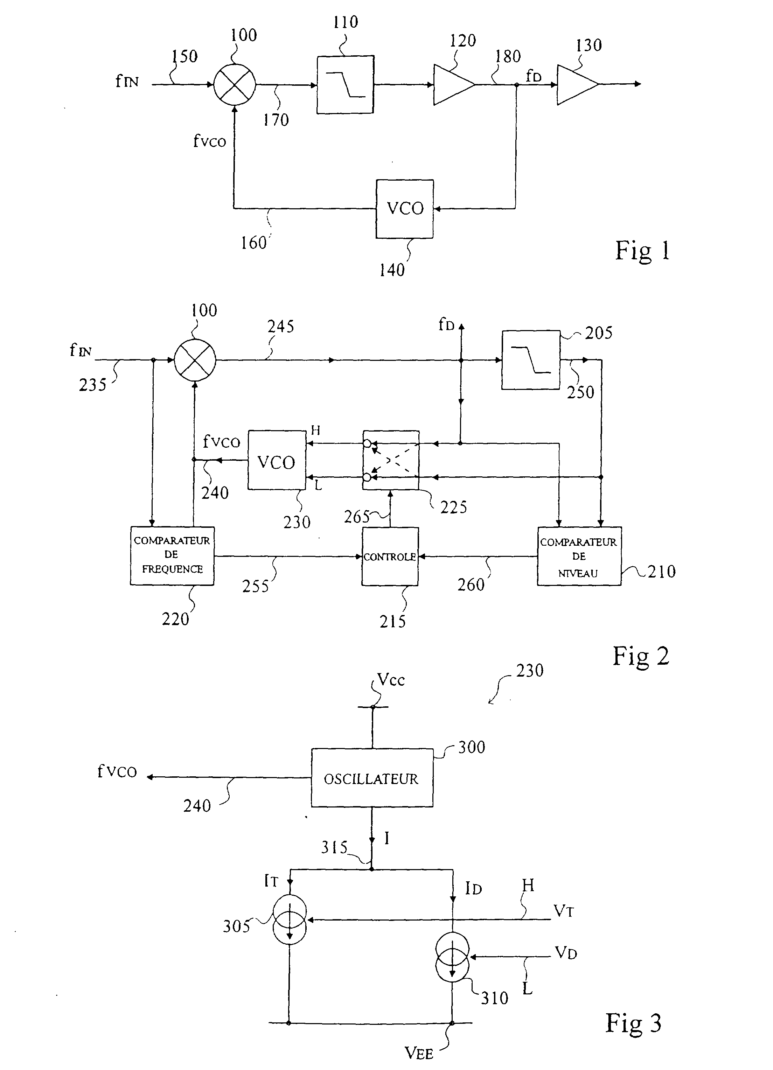

La figure 1 représente sous forme de blocs le schéma d'un PLL classique de démodulation FM. Ce PLL comprend un mélangeur 100, quelquefois appelé multiplieur, un filtre passe-bas 110, un amplificateur tampon 120, un amplificateur 130 et un oscillateur à fréquence commandée par la tension (VCO) 140.

Le mélangeur 100 reçoit et mélange des signaux $f_{IN}$ et $f_{VCO}$ qui sont respectivement présents sur ses entrées 150 et 160, l'entrée 160 étant la sortie du VCO 140. La sortie 170 du mélangeur, qui comporte le signal audio démodulé $f_D$, est transmise par le filtre 110 et le tampon 120. La sortie 180 du tampon est connectée aux entrées de l'amplificateur 130 et du VCO 140.

Le signal d'entrée modulé en fréquence $f_{IN}$ est un signal composite qui peut correspondre à l'une quelconque d'une pluralité de fréquences porteuses qui s'étalent sur une large plage de fréquence. Un problème associé au système illustré en figure 1 est que, comme les fréquences porteuses s'étendent sur une large plage de fréquence, l'oscillateur VCO 140 devra avoir un gain élevé, typiquement plusieurs MHz/Volt, pour permettre au PLL de se verrouiller sur l'une quelconque de la pluralité de fréquences porteuses. Ainsi, des fréquences porteuses qui s'étalent sur une grande plage dynamique nécessitent que le VCO ait un gain élevé et une plage de fréquence supérieure à la plage de fréquence des porteuses. Toutefois, l'utilisation d'un VCO à gain élevé entraîne que le signal audio démodulé $f_D$ a une faible amplitude, typiquement dans la plage de quelques dizaines de millivolts, d'où il résulte un signal audio démodulé $f_D$ qui a un mauvais rapport signal sur bruit. Le signal audio démodulé $f_D$ doit alors être amplifié par l'amplificateur 130 pour obtenir un plus grand signal utile. Toutefois, le bruit indésiré sera également amplifié de la même quantité que le signal audio désiré. En conséquence, les rapports signal sur bruit respectifs à l'entrée et à la sortie de l'amplificateur 130 seront sensiblement identiques. En outre, un VCO à gain élevé présentera de mauvaises caractéristiques de linéarité qui affecteront la qualité du signal audio démodulé $f_D$.

De façon idéale, le signal audio requis, qui est superposé au signal de porteuse, devrait être démodulé par un VCO à faible gain de sorte que le signal audio démodulé $f_D$ ait une amplitude de quelques centaines de millivolts, ce qui assure un bon rapport signal sur bruit.

En conséquence, avec le système de la figure 1, on arrive à un conflit entre les exigences de gain du VCO dans les modes de verrouillage et de démodulation.

Il faut noter que la caractéristique de gain en fonction de la fréquence du système de la figure 1 est sensiblement plate.

Un objet de la présente invention est de prévoir un PLL de démodulation qui présente un rapport signal sur bruit amélioré.

Un autre objet de l'invention est de prévoir un PLL de démodulation qui présente des caractéristiques améliorées de linéarité de démodulation.

Ces objets sont atteints selon la présente invention par un PLL de démodulation qui présente une boucle à fort gain pour son verrouillage et une boucle à faible gain pour la démodulation. Plus particulièrement, la présente invention prévoit une boucle verrouillée en phase de démodulation comprenant un mélangeur connecté à un oscillateur commandé, ayant une entrée de commande de gain faible, une entrée de commande de gain fort, et une sortie connectée à une entrée du mélangeur ; un filtre passe-bas ayant son entrée connectée à la sortie du mélangeur ; un comparateur de niveau qui fournit une sortie active quand les niveaux de signal sur l'entrée et la sortie du premier filtre ont suffisamment convergé ; un comparateur de fréquence qui fournit une sortie active quand les fréquences du signal sur les première et seconde entrées du mélangeur ont suffisamment convergé ; un commutateur commandé ayant une première position dans laquelle l'entrée et la sortie du premier filtre sont respectivement connectées à des entrées de gain élevé et de gain faible de l'oscillateur commandé et une seconde position dans laquelle l'entrée et la sortie du premier filtre sont respectivement connectées aux entrées de gain faible et de gain fort de l'oscillateur ; et des moyens de commande couplés audit comparateur de niveau et audit comparateur de fréquence, pour sélectionner la première position du commutateur quand les fréquences du signal sur les première et seconde entrées du mélangeur n'ont pas suffisamment convergé et la seconde position du commutateur quand les fréquences du signal sur les entrées du mélangeur et les niveaux de signal sur l'entrée et la sortie du filtre ont suffisamment convergé.

Selon un mode de réalisation de la présente invention, l'oscillateur commandé comprend un oscillateur commandé en courant et des première et seconde sources de courant commandées en tension qui ont respectivement des entrées de commande qui correspondent aux entrées de gain fort et de gain faible de l'oscillateur commandé, pour commander la fréquence de l'oscillateur commandé en courant.

Selon un mode de réalisation de la présente invention, la seconde source de courant commandée en tension a des caractéristiques très linéaires.

Selon un mode de réalisation de la présente invention, la boucle comprend un deuxième filtre passe-bas et un tampon qui sont connectés en aval du mélangeur et en amont du premier filtre, du commutateur commandé et du comparateur de niveau.

Selon un mode de réalisation de la présente invention, le premier filtre est un filtre à résistance et condensateur.

Selon un mode de réalisation de la présente invention, il est prévu un moyen pour réduire la valeur de la résistance du premier filtre quand le commutateur est dans sa première position.

La présente invention s'applique à un récepteur de satellite, un système radio, ou un système de télévision incluant un système de télévision par câble.

Ces objets, caractéristiques et avantages ainsi que d'autres de la présente invention seront décrits en détail dans la description suivante de modes de réalisation particuliers faite, à titre non-limitatif, en relation avec les figures jointes parmi lesquelles :

la figure 1 est un schéma sous forme de blocs d'une boucle à verrouillage de phase (PLL) classique de démodulation d'un signal modulé en fréquence (FM) ;

la figure 2 est un schéma sous forme de blocs d'un mode de réalisation d'un PLL de démodulation FM selon l'invention ;

la figure 3 représente sous forme de blocs un mode de réalisation du VCO de la figure 2 ;

la figure 4A est un schéma de circuit d'une source de courant à gain élevé de la figure 3 ;

la figure 4B représente la caractéristique de transfert du circuit de la figure 4A ;

la figure 5A est un schéma de circuit d'une source de courant à faible gain de la figure 3 ;

la figure 5B représente la caractéristique de transfert du circuit de la figure 5A ;

la figure 6 est un schéma sous forme de blocs d'un mode de réalisation d'un bloc de commande de la figure 2 ;

la figure 7A est un schéma sous forme de blocs d'un mode de réalisation d'un comparateur de niveau de la figure 2 ;

la figure 7B représente la relation entre des signaux du schéma de la figure 7A ;

la figure 8A représente un schéma sous forme de blocs d'un mode de réalisation d'un comparateur de fréquence de la figure 2 ;

la figure 8B représente la tension de sortie du filtre de la figure 8A en fonction de la différence de fréquence entre la fréquence d'entrée et la fréquence du VCO quand la différence de fréquence est supérieure à environ 1 MHz ;

la figure 8C représente la tension de sortie du filtre de la figure 8A en fonction de la différence de fréquence entre la fréquence d'entrée et la fréquence du VCO quand la différence de fréquence est inférieure à environ 1 MHz ;

la figure 8D représente la tension de sortie du filtre de la figure 8A en fonction de la différence de fréquence entré la fréquence d'entrée et la fréquence du VCO quand la différence de fréquence est sensiblement nulle ;

la figure 9A représente un mode de réalisation d'un accélérateur pour réduire la constante de temps du filtre passe-bas de la figure 2A ; et

la figure 9B représente une variante du circuit de la figure 9A.

En figure 2, un PLL de démodulation FM selon la présente invention comprend un mélangeur 100, un filtre passe-bas 205, un comparateur de niveau 210, un bloc de commande 215, un comparateur de fréquence 220, un commutateur double 225 et un oscillateur commandé en tension 230 à double entrée. Ce PLL de démodulation FM comprend aussi un filtre passe-bas 110 et un tampon 120, tels que représentés en figure 1, qui n'ont pas été illustrés dans cette figure 2 par souci de clarté ; le filtre passe-bas 110 filtrera les composantes "somme" à haute fréquence du mélangeur tandis que le tampon 120 adaptera l'impédance du filtre passe-bas aval 205 sans affecter l'impédance du filtre passe-bas amont 110.

Le signal d'entrée FM composite $f_{IN}$ est fourni aux premières entrées communes 235 du mélangeur 100 et du comparateur de fréquence 220 dont les secondes entrées communes 240 sont connectées à la sortie du VCO 230. Les sorties 240, 245 du VCO 230 et du mélangeur 100 sont polarisées en continu selon la fréquence porteuse requise. La sortie 245 du mélangeur 100 est connectée à l'entrée du filtre passe-bas 205, à une première entrée du commutateur 225 et à une première entrée du comparateur de niveau 210. La sortie 250 du filtre passe-bas 205 est connectée aux secondes entrées communes du commutateur 225 et du comparateur de niveau 210. Les sorties respectives 255, 260 des comparateurs de fréquence et de niveau 220 et 210 sont connectées au bloc de commande 215 dont la sortie 265 commande le commutateur 225 en réponse à ses entrées (255, 260). Les première et seconde sorties H et L du commutateur 225 sont respectivement connectées aux première et seconde entrées du VCO 230 et correspondent respectivement à une entrée à gain élevé H et à une entrée à gain faible L.

Le schéma de la figure 2 a deux modes de fonctionnement. Dans le premier mode, le PLL réalise un accord et "se verrouille" seulement sur la fréquence porteuse requise, tandis que, dans le second mode, le PLL démodule le signal audio de la fréquence porteuse verrouillée.

Pour rendre l'analyse ci-après plus compréhensible, on supposera un cas où l'on a les valeurs numériques suivantes :

fréquence d'entrée ($f_{IN}$) : de 4,5 à 6,5 MHz ;
entrée à gain élevé (H) du VCO 3 MHz/V (polarisation continue de 5 V pour 6 MHz) ;
entrée à faible gain (L) du VCO - 70 kHz/V ;
fréquence de coupure du filtre passe-bas 205 : 0,7 Hz.

Ces valeurs sont données uniquement à titre d'exemple et ne doivent pas être interprétées limitativement quant à la portée de la présente invention.

Dans le premier mode de fonctionnement, le commutateur 255 est dans sa première position (représentée en traits pleins) dans laquelle ses première et seconde entrées 245, 250 sont respectivement connectées aux entrées de gain H et L du VCO 230. Le gain à basse fréquence de ce système pendant ce mode d'accord est déterminé par la somme des gains des entrées de gain fort et faible H et L du VCO. Cette somme des gains est due au fait que le filtre passe-bas de 205 a un effet minimum sur son signal d'entrée quand ce signal d'entrée a une fréquence $f_S$ qui est inférieure à celle de la fréquence de coupure (dans cet exemple 0,7 Hz) du filtre passe-bas 205. En conséquence, quand

$$0 \le f_s \le 0,7 \text{ Hz,}$$

le gain d'ensemble à fréquence basse de ce système est 3,07 MHz/V (3,0+0,07 MHz/V). Toutefois, le gain à haute fréquence de ce système pendant ce mode d'accord est déterminé par l'entrée de gain fort H du VCO. Ce gain de l'entrée H est dû au fait que le filtre passe-bas 205 atténue sensiblement son signal d'entrée quand ce signal d'entrée a une fréquence $f_s$ supérieure à celle de la fréquence de coupure (0,7 Hz) du filtre passe-bas 205. En conséquence, quand $f_s > 0,7$ Hz, le gain d'ensemble à fréquence haute de ce système est 3,0 MHz/V. Ainsi, dans ce premier mode, c'est sensiblement la composante continue de la sortie 245 du mélangeur 100 (et bien sûr la sortie 240 du VCO 230) qui a un gain élevé de façon à assurer un verrouillage rapide et convenable de la porteuse, un éventuel signal audio démodulé ayant très peu d'influence sur le gain du système.

Le PLL tendra à se verrouiller sur la fréquence porteuse requise sensiblement de la même façon que le PLL de la figure 1. Toutefois, l'agencement de la figure 2 comprend un bloc de commande de commutateur 215 qui répond aux sorties respectives 255, 260 des comparateurs de fréquence et de niveau 220, 210 de sorte que, quand les fréquences des signaux sur les entrées 235, 240 du mélangeur 100 sont sensiblement égales, le comparateur de fréquence fournit un signal actif, par exemple un signal logique 1, et, quand les niveaux des signaux sur les entrées 245, 250 du commutateur 225 sont sensiblement égaux, le comparateur de niveau fournit un signal actif. Le bloc de commande 215 répond aux signaux actifs des deux comparateurs de façon à commuter le commutateur 225 de sa première à sa seconde position (représentée en pointillés). Le bloc de commande 215 ramènera le commutateur 225 à sa première position de préférence seulement quand le signal de sortie du comparateur de fréquence 220 passe par exemple d'un état logique 1 à un état logique 0, quel que soit l'état du signal de sortie du comparateur de niveau 210, c'est-à-dire que le bloc de commande agit en tant que verrou. Quand le commutateur passe de sa première à sa seconde position, le PLL passe de son premier à son second mode fonctionnel.

Dans le second mode fonctionnel, le commutateur 255 est dans sa seconde position dans laquelle ses première et seconde entrées 245, 250 sont respectivement connectées aux entrées de gain faible et fort L et H du VCO 230. Comme dans le cas du premier mode, le gain à fréquence faible de ces systèmes, pendant son second mode, de démodulation, est déterminé par la somme des gains des entrées de gain fort et faible H et L du VCO. En conséquence, quand $0 \le f_s \le 0,7$Hz, le gain d'ensemble à fréquence basse du système est 3,07 MHz/V. Toutefois, ce gain haute fréquence du système pendant son mode de démodulation est déterminé par l'entrée de gain faible L du VCO. Ce gain d'entrée L est dû au fait que le filtre passe-bas 205 atténue sensiblement son signal d'entrée quand ce signal d'entrée a une fréquence $f_s$ supérieure à celle de fréquence de coupure (0,7 Hz) du filtre passe-bas 205. En conséquence, quand $f_s > 0,7$ Hz, le gain d'ensemble à haute fréquence du système est 0,07 MHz/V ou 70 kHz/V. Pendant ce second mode, c'est sensiblement la composante audio alternative de la sortie 245 du mélangeur 100 (et bien sûr la sortie 240 du VCO 230) qui a un gain faible de façon à fournir un signal audio démodulé important $f_D$ qui a un bon rapport signal-sur-bruit, le signal continu ayant très peu d'influence sur le gain du système ; toutefois, ce signal continu est toujours présent assurant ainsi le verrouillage du système sur la porteuse requise.

En conséquence, le gain en fonction de la fréquence du VCO passe de 3,07 MHz/V pour 0,7 Hz à 70 kHz/V, pour 30 Hz ; 30 Hz correspondant à la fréquence pour laquelle le gain du VCO égale 70 kHz/V plus 3dB. Dans ce cas, le signal audio est démodulé par un VCO à faible gain d'où il résulte un signal audio démodulé $f_D$ de quelques centaines de millivolts. En conséquence, le rapport signal sur bruit de ce signal audio démodulé $f_D$ sera meilleur que pour le signal audio démodulé $f_D$ associé à la figure 1.

La figure 3 est un schéma sous forme de blocs d'un mode de réalisation du VCO de la figure 2. Le VCO 230 comprend un oscillateur 300 et deux sources de courant commandées 305, 310. L'oscillateur 300 est de préférence un oscillateur classique commandé en courant tel qu'un oscillateur à émetteurs couplés. Il est alimenté par une source de tension positive VCC et fournit un signal de fréquence $f_{VCO}$ sur la sortie 240 et un courant I sur une sortie 315. La fréquence du signal $f_{VCO}$ est proportionnelle au courant I.

Les bornes des sources de courant 305, 310, du côté haute tension, sont connectées à la sortie 315 et leurs bornes du côté basse tension sont connectées à une autre source de tension VEE qui est moins positive que la source de tension VCC. La source de courant 305 correspond à une source de courant à gain élevé qui est commandée par une "tension d'accord" VT sur l'entrée H et laisse passer un courant IT, tandis que la source de courant 310 correspond à une source de courant de gain faible qui est commandée pendant la démodulation par une "tension de démodulation" VD sur l'entrée L, et laisse passer un courant ID. Le courant I est la somme des courants IT et ID. Les sources de courant 305 et 310 sont commandées par les tensions VT, VD sur leurs entrées respectives H et L de sorte que le courant I est démodulé autour d'une valeur centrale qui module elle-même le signal de fréquence de sortie $f_{VCO}$ autour d'une fréquence centrale $F_0$.

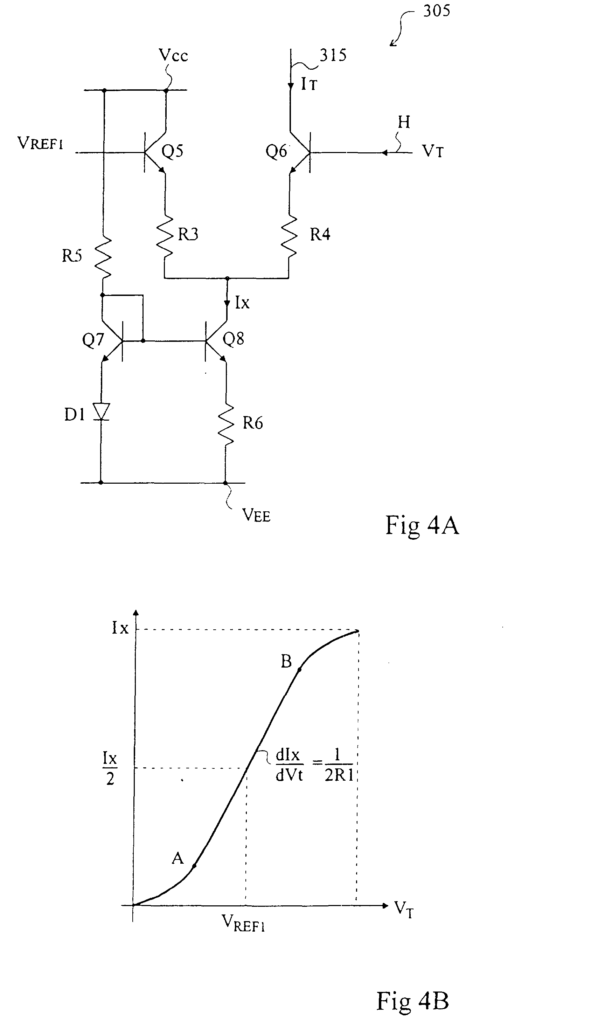

La figure 4A représente un schéma de circuit d'un mode de réalisation de la source de courant de gain élevé 305 de la figure 3 et la figure 4B représente la caractéristique de transfert de la source de courant de gain élevé de la figure 4A. Cette source de courant de gain élevé 305 comprend quatre transistors NPN Q5-Q8 et quatre résistances R3-R6. Le gain de cette source de courant est sensiblement proportionnel au rapport de résistances R3/R6 ; les résistances R3 et R4 ont la même valeur. Le collecteur du transistor Q5 est connecté à la tension VCC, son émetteur est connecté au collecteur du transistor Q8 par l'intermédiaire d'une résistance R3 et sa base est polarisée par une tension de référence $V_{REF1}$. Le collecteur du transistor Q6 correspond à la sortie 315, son émetteur est connecté au collecteur du transistor Q8 par une résistance R4 et sa base correspond à l'entrée H. L'émetteur du transistor Q8 est connecté à la tension VEE par l'intermédiaire de la résistance R6. Le collecteur du transistor Q7 est connecté à la tension VCC par l'intermédiaire de la résistance R5. Les bornes de base des transistors Q7 et Q8 sont connectées au collecteur du transistor Q7. L'émetteur du transistor Q7 est de préférence connecté à la tension VEE par l'intermédiaire d'une diode D1 qui assure une compensation en température en association avec un oscillateur à émetteurs couplés. La diode D1 peut être constituée d'un transistor NPN connecté en diode.

Cette source de courant 305 est en fait un amplificateur différentiel associé à un miroir de courant. Le courant extrait $I_x$ est donné par la relation :

$$I_x = V_{BE(diode)}/R6.$$

En conséquence, le courant IT est en première approximation donné par la relation :

$$IT = I_x/2 + (VT - V_{REF1})/2R3 = (V_{BE}/2R6) + (VT - V_{REF1})/2 ;$$

qui se ramène à $IT = V_{BE}/2R6$ quand $VT = V_{REF1}$.

La fréquence centrale $F_0$ du PLL est proportionnelle à:

$$IT[(V_{BE}/2R6) + (VT - V_{REF1})/2R3].$$

Le gain de la source de courant commandée en tension 305 est donné par la relation $dIT/dVT = 1/2R3$ et le gain du VCO, pour l'entrée H de gain élevé, est proportionnel à IT.

Comme le représente la figure 4B, la caractéristique de transfert est linéaire en pratique seulement autour du point $[V_{REF}, I_x/2]$, c'est-à-dire entre les points A et B.

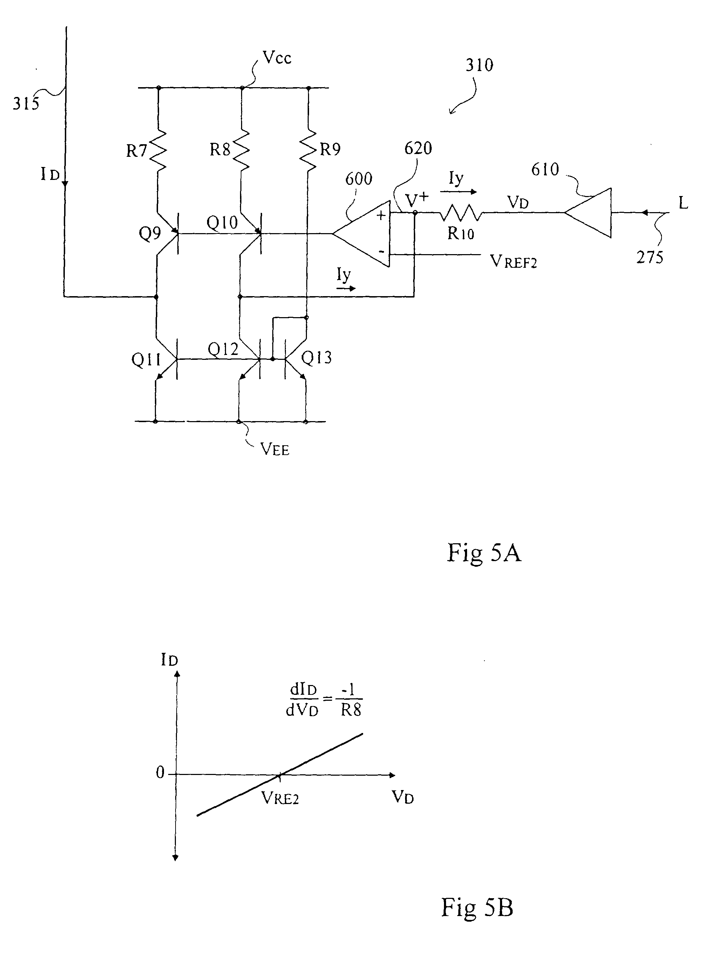

La figure 5A représente un schéma de circuit d'un mode de réalisation de la source de courant de gain faible 310 de la figure 3 et la figure 5B représente la caractéristique de transfert de cette source de courant. Cette source de courant de gain faible 310 comprend deux transistors PNP Q9-Q10 ; trois transistors NPN Q11-Q13 ; quatre résistances R7-R10 ; un amplificateur opérationnel 600 et un amplificateur tampon 610.

Les émetteurs des transistors Q9 et Q10 sont connectés à la tension VCC par l'intermédiaire de résistances respectives R7 et R8. Les collecteurs des transistors Q9 et Q10 sont respectivement connectés aux collecteurs des transistors Q11 et Q12 dont les émetteurs sont connectés à la tension VEE. Les collecteurs des transistors Q9 et Q11 sont connectés à la sortie 315 et reçoivent le courant ID (figure 3). Les bornes de base des transistors Q11 et Q12 sont connectées à la base et au collecteur du transistor Q13. Le collecteur du transistor Q13 est connecté à la tension VCC par l'intermédiaire de la résistance R9. Le transistor Q13 agit comme transistor d'entrée d'un miroir de courant ayant les transistors Q11 et Q12 comme transistors de sortie. La sortie L du commutateur 225 est connectée à l'entrée du tampon 610 qui est de préférence un amplificateur de gain unité. La sortie du tampon 610, qui est à la tension VD, est connectée à l'entrée positive 620 de l'amplificateur 600 par la résistance R10. L'entrée 620 est une tension désignée par $V^+$. Les collecteurs des transistors Q10 et Q12 sont connectés à l'entrée positive 620 de l'amplificateur. L'entrée négative de l'amplificateur 600 est connectée à une source de tension de référence $V_{REF2}$. Les bornes de base des transistors Q9 et Q10 sont connectées à la sortie 620 de l'amplificateur 600.

L'amplificateur 600 agit pour que ses entrées positive et négative soient toujours identiques ; ainsi $V^+ = V_{REF2}$. Ceci amène un courant $I_Y$ à circuler du collecteur du transistor Q10 à travers la résistance R10, cette valeur de courant étant donnée par la relation :

$$I_Y = [V^+ - VD]/R10 = (V_{REF2} - VD)/R10.$$

En conséquence, le courant $I_D$ est obtenu par une recopie du courant $I_Y$ de sorte que :

$$ID = -I_Y = -(V_{REF2} - VD)/R10.$$

La fréquence de modulation $F_M$ est proportionnelle à ID et donc à $-(V_{REF2} - VD)/R10$.

Si l'amplificateur 600 a un gain élevé, ceci permet à la réponse en courant en fonction de la tension d'être extrêmement linéaire, comme cela est illustré en figure 5B.

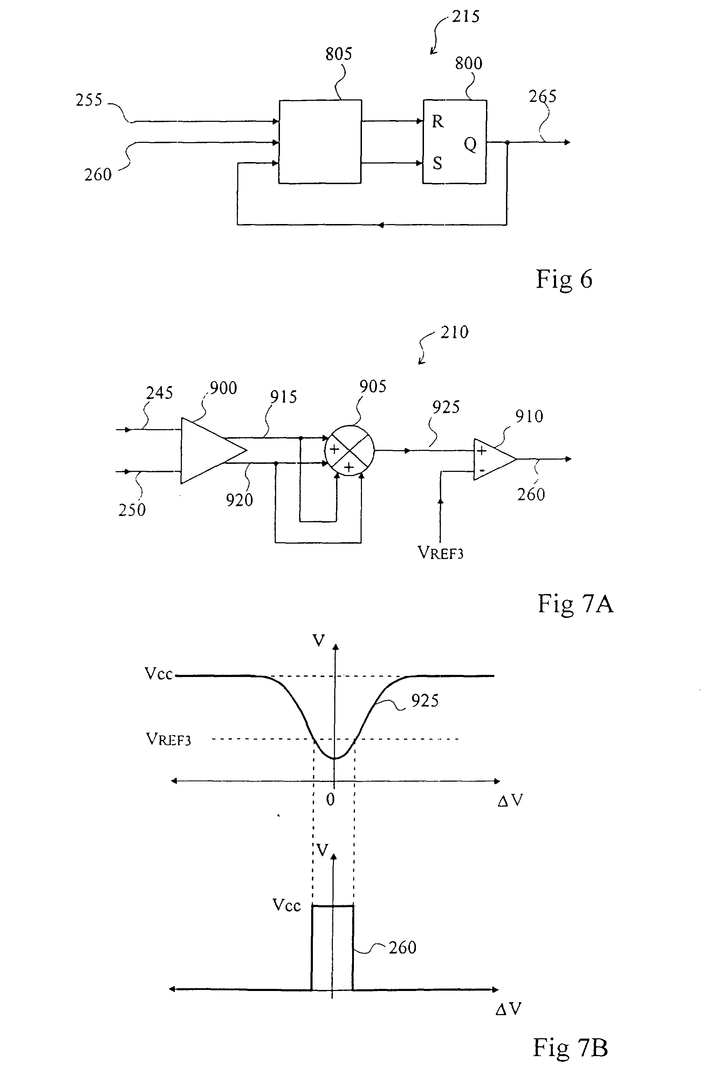

La figure 6 est un schéma sous forme de blocs d'un mode de réalisation du bloc de commande 215 de la figure 2. Ce bloc de commande 215 comprend une bascule du type RS 800 et un bloc logique 805. Les sorties respectives 255, 260, 265 du comparateur de fréquence 220, du comparateur de niveau 210 et de la bascule 800 sont envoyées au bloc logique 805.

La bascule 800 et le bloc logique 805 sont disposés par exemple de sorte que la sortie 265 de la bascule 800 a un état logique 0 à moins que les entrées 255, 260 aient toutes deux des états logiques 1, c'est-à-dire à moins que les fréquences des signaux sur les entrées 235, 240 du mélangeur 200 soient sensiblement égales et que les niveaux des signaux sur les entrées 245, 250 du commutateur 225 soient sensiblement égaux. Quand les entrées 255, 260 ont toutes deux des états logiques 1, la sortie 265 de la bascule 800 passe d'un état logique 0 à un état logique 1 et reste à l'état logique 1 jusqu'à ce que la sortie 255 du comparateur de fréquence 220 change d'état pour indiquer que la fréquence du PLL n'est pas "verrouillée" quel que soit l'état du signal en provenance du comparateur de niveau 210, c'est-à-dire que la bascule 800 et le bloc logique 805 agissent comme un verrou.

La figure 7A est un schéma sous forme de blocs d'un mode de réalisation du comparateur de niveau 210 de la figure 2. Ce schéma représente un amplificateur 900, un mélangeur 905 et un comparateur 910.

L'amplificateur 900, qui fournit des sorties différentielles 915, 920, reçoit des entrées en provenance de l'entrée 245 et de la sortie 250 du filtre 205. Les sorties 915, 920 sont connectées au mélangeur 905 qui réalise une fonction d'élévation au carré, c'est-à-dire une fonction $X^2$, sur la différence de tension inversée et non-inversée $\Delta V$ des signaux sur ces sorties 915, 920. La sortie 925 du mélangeur est connectée à l'entrée positive du comparateur 910 dont l'entrée négative est polarisée par une tension de référence $V_{REF3}$ et dont la sortie 260 fournit un signal logique.

La figure 7B représente la relation entre les signaux qui sont présents sur les sorties 925 et 260 de la figure 7A. Le signal supérieur représente le produit de la différence de tension $\Delta V$ inversée et non-inversée des signaux présents sur les sorties 915 et 920 de l'amplificateur 900. Le signal inférieur représente le signal sur la sortie 260 du comparateur 910. Quand la tension sur la sortie 925 du mélangeur 905 est inférieure à $V_{REF3}$, la sortie 260 du comparateur a un état logique 1 et, quand la tension sur la sortie 925 du mélangeur 905 est supérieure à $V_{REF3}$, la sortie 260 du comparateur a un état logique 0.

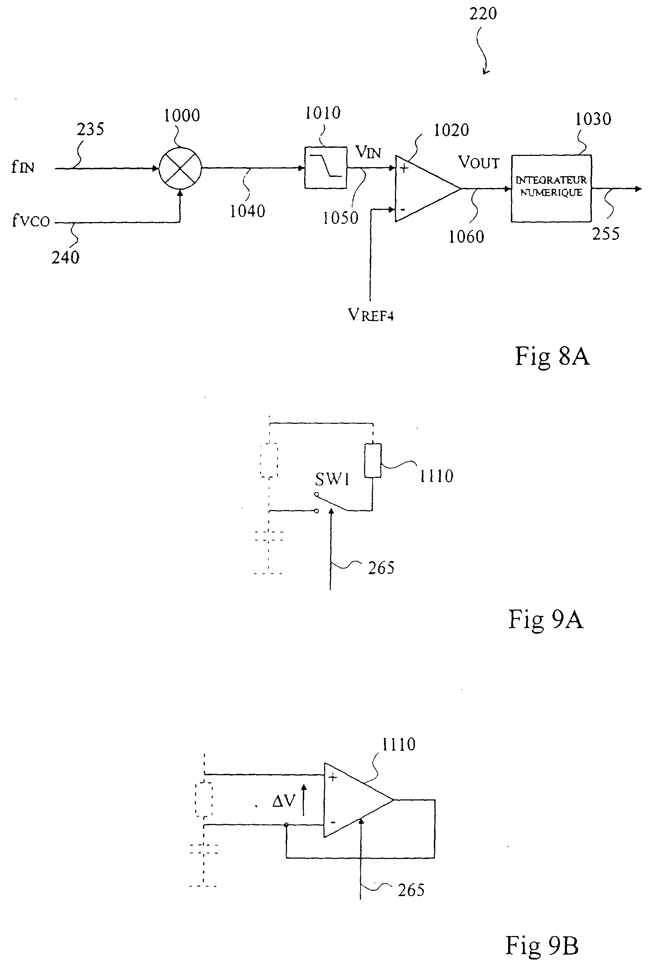

La figure 8A est un schéma sous forme de blocs d'un mode de réalisation du comparateur de fréquence 220 de la figure 2. Ce schéma représente un mélangeur 1000, un filtre passe-bas 1010, un comparateur 1020 et un intégrateur numérique 1030.

Le mélangeur 1000 mélange les signaux respectifs $f_{IN}$, $f_{VCO}$ sur les entrées 235, 240 et fournit une sortie 1040 qui est connectée au filtre 1010. Le filtre 1010 a par exemple une fréquence de coupure de 400 kHz. La sortie 1050 du filtre 1010, qui est une tension $V_{IN}$, est connectée à l'entrée positive du comparateur 1020 dont l'entrée négative est polarisée par une tension de référence $V_{REF4}$. Le comparateur 1020 fournit un signal logique $V_{OUT}$ sur sa sortie 1060 qui est connectée à l'entrée de l'intégrateur 1030. La sortie de l'intégrateur 1030 constitue la sortie 255.

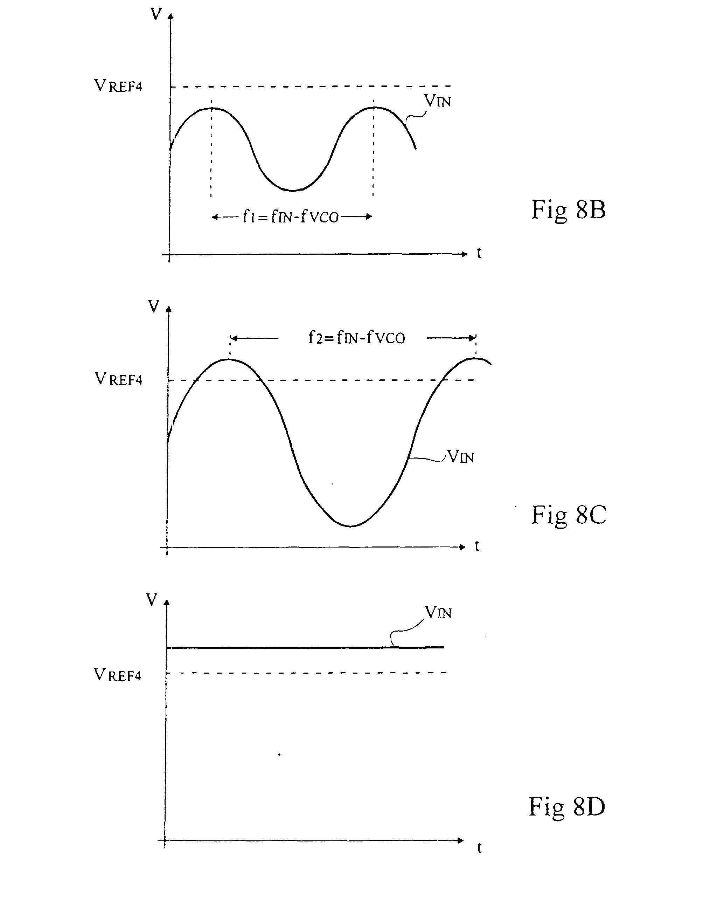

La figure 8B représente la tension $V_{IN}$, c'est-à-dire la tension de sortie du filtre 1010, quand la différence de fréquence $f_1$ entre $f_{IN}$ et $f_{VCO}$ est supérieure à environ 1 MHz. Le filtre 1010 élimine par filtrage les composantes de fréquence supérieures à environ 400 kHz et ceci laisse un signal dont la valeur de crête n'est jamais supérieure à la référence $V_{REF4}$. En conséquence, la sortie du comparateur 1020 et de l'intégrateur est toujours à un niveau logique 0.

La figure 8C représente la tension $V_{IN}$ quand la différence de fréquence $f_2$ entre $f_{IN}$ et $f_{VCO}$ est inférieure à environ 1 MHz. A nouveau, le filtre 1010 élimine par filtrage les composantes de fréquences supérieures à environ 400 kHz. Toutefois, dans ce cas, $V_{IN}$ a une valeur de crête qui est parfois supérieure à la référence $V_{REF4}$ puisque le filtre 1010 a moins d'influence sur son signal d'entrée. Il en résulte un signal de sortie $V_{IN}$ de plus grande amplitude. En conséquence, la sortie du comparateur 1020 aura un état logique 1 chaque fois que $V_{IN}$ est supérieure à $V_{REF4}$. L'intégrateur agit comme un filtre par rapport à la sortie du comparateur et peut être disposé de sorte qu'il aura un état logique 0 jusqu'à ce que les fréquences $f_{IN}$, $f_{VCO}$ aient suffisamment convergé, par exemple quand les fréquences $f_{IN}$, $f_{VCO}$ sont à moins de 100 kHz l'une de l'autre.

La figure 8D représente la tension $V_{IN}$ quand la différence de fréquence $f_2$ entre $f_{IN}$ et $f_{VCO}$ est sensiblement nulle. Dans ce cas, la tension $V_{IN}$ est sensiblement une tension continue qui est toujours supérieure à $V_{REF4}$ et, en conséquence, les sorties respectives 1060 et 255 du comparateur et de l'intégrateur ont des états logiques 1.

Les figures 9A et 9B représentent deux modes de réalisation d'un accélérateur qui peut être utilisé en relation avec la présente invention pour réduire la constante de temps du filtre passe-bas 205 de la figure 2 quand le filtre 205 est un filtre passe-bas RC, comme cela est représenté en pointillés.

La fonction de base de l'accélérateur est de réduire, pendant le mode "d'accord", c'est-à-dire pendant le premier mode fonctionnel, la résistance du filtre passe-bas 205 de sorte que le condensateur de ce filtre peut se charger plus rapidement, c'est-à-dire que le condensateur peut suivre plus rapidement la tension d'entrée du filtre. En figure 9A, l'accélérateur est une résistance commutée 1100 placée en parallèle sur la résistance du filtre. La résistance commutée est commandée par la sortie 265 du bloc de commande de sorte que, quand le système est dans son premier mode fonctionnel, la résistance commutée est placée en parallèle avec la résistance du filtre et, quand le système est dans son second mode fonctionnel, c'est-à-dire le mode de "démodulation", la résistance commutée n'a pas d'effet sur la résistance du filtre.

A titre de variante, comme cela est représenté en figure 9B, la résistance commutée peut être réalisée sous forme d'un amplificateur à transconductance convenablement connecté et commandé 1110.

La présente invention peut être adaptée pour être avantageusement utilisée à la démodulation, de préférence mais non nécessairement à la démodulation FM, du son dans des systèmes de radio ou de télévision et/ou des systèmes vidéo et/ou des systèmes de récepteurs de satellite.

## Revendications

1.  Boucle verrouillée en phase de démodulation comprenant un mélangeur (100) connecté à un oscillateur commandé (230), caractérisée en ce qu'elle comprend :

    ledit oscillateur commandé (230) ayant une entrée de commande de gain faible (L), une entrée de commande de gain fort (H), et une sortie (240) connectée à une première entrée du mélangeur (100) ;
    un premier filtre passe-bas (205) ayant son entrée connectée à la sortie (245) du mélangeur (100) ;
    un comparateur de niveau (210) qui fournit une sortie active (260) quand les niveaux de signal sur l'entrée (245) et la sortie (250) du premier filtre (205) ont suffisamment convergé ;
    un comparateur de fréquence (220) qui fournit une sortie active (255) quand les fréquences du signal ($f_{VCO}$, $f_{IN}$) sur les première et seconde entrées (240, 235) du mélangeur (100) ont suffisamment convergé ;
    un commutateur commandé (225) ayant une première position dans laquelle l'entrée et la sortie (245, 250) du premier filtre (205) sont respectivement connectées à des entrées de gain élevé (H) et de gain faible (L) de l'oscillateur commandé (230) et une seconde position dans laquelle l'entrée et la sortie (245, 250) du premier filtre (205) sont respectivement connectées aux entrées de gain faible (L) et de gain fort (H) de l'oscillateur (230) ; et
    des moyens de commande (215) couplés audit comparateur de niveau et audit comparateur de fréquence, pour sélectionner la première position du commutateur (225) quand les fréquences du signal sur les première et seconde entrées (240, 235) du mélangeur (100) n'ont pas suffisamment convergé et la seconde position du commutateur (225) quand les fréquences du signal sur les première et seconde entrées (240, 235) du mélangeur (100) et les niveaux de signal sur l'entrée et la sortie (245, 250) du premier filtre (205) ont suffisamment convergé.

2.  Boucle verrouillée en phase de démodulation selon la revendication 1, caractérisée en ce que l'oscillateur commandé (230) comprend un oscillateur commandé en courant (300) et des première et seconde sources de courant commandées en tension (305, 310) qui ont respectivement des entrées de commande qui correspondent aux entrées de gain élevé et de gain faible (H, L) de l'oscillateur commandé (230) pour commander la fréquence de l'oscillateur commandé en courant (300).

3.  Boucle verrouillée en phase de démodulation selon la revendication 2, caractérisée en ce que la seconde source de courant commandée en tension (310) a des caractéristiques fortement linéaires.

4.  Boucle verrouillée en phase de démodulation selon l'une quelconque des revendications 1 à 3, caractérisée en ce qu'elle comprend un deuxième filtre passe-bas (110) et un tampon (120) qui sont connectés en aval du mélangeur (100) et en amont du premier filtre (205), du commutateur commandé (225) et du comparateur de niveau (210).

5.  Boucle verrouillée en phase de démodulation selon l'une quelconque des revendications 1 à 4, caractérisée en ce que le premier filtre (205) est un filtre à résistance et condensateur.

6.  Boucle verrouillée en phase de démodulation selon la revendication 5, caractérisée en ce qu'elle comprend un moyen pour réduire la valeur de la résistance du premier filtre (205) quand le commutateur (225) est dans sa première position.

7.  Système récepteur de satellite, caractérisé en ce qu'il comprend une boucle verrouillée en phase de démodulation selon l'une quelconque des revendications 1 à 6.

8.  Système radio, caractérisé en ce qu'il comprend une boucle verrouillée en phase de démodulation selon l'une quelconque des revendications 1 à 6.

9.  Système de télévision, caractérisé en ce qu'il comprend une boucle verrouillée en phase de démodulation selon l'une quelconque des revendications 1 à 6.

## Claims

1. A demodulation phase-locked loop including a mixer (100) connected to a controlled oscillator (230), characterized in that it comprises:

    said controlled oscillator (230) having a low gain control input (L), a high gain control input (H), and an output (240) connected to a first input of the mixer (100);
    a first low-pass filter (205) having its input connected to the output (245) of the mixer (100);
    a level comparator (210) which provides an output (260) that is active when the signal levels at the input (245) and the output (250) of the first filter (205) have sufficiently converged;
    a frequency comparator (220) which provides an output (255) that is active when the signal frequencies ($f_{VCO}$, $f_{IN}$) at the first and second inputs (240, 235) of the mixer (100) have sufficiently converged;
    a controlled switch (225) having a first position in which the input and the output (245, 250) of the first filter (205) are respectively connected to the high gain (H) and to low gain (L) inputs of the controlled oscillator (230), and a second position in which the input and the output (245, 250) of the first filter (205) are connected to the low gain (L) and the high gain (H) inputs of the oscillator (230), respectively; and
    control means (215), coupled to said level comparator and said frequency comparator, for selecting the first position of the switch (225) when the frequencies of the signal on the first and second inputs (240, 235) of the mixer (100) have not sufficiently converged and the second position of the switch (225) when the frequencies of the signal on the first and second inputs (240, 235) of the mixer (100) and the levels of the signal at the input and the output (245, 250) of the first filter (205) have sufficiently converged.

2. The demodulation phase-locked loop of claim 1, characterized in that the controlled oscillator (230) comprises a current-controlled oscillator (300) and first and second voltage-controlled current sources (305, 310) that have control inputs which correspond to the high gain and to the low gain (H, L) inputs of the controlled oscillator (230), respectively, to control the frequency of the current-controlled oscillator (300).

3. The demodulation phase-locked loop of claim 2, characterized in that the second voltage-controlled current source (310) has very linear characteristics.

4. The demodulation phase-locked loop of any of claims 1 to 3, characterized in that it comprises a second low-pass filter (110) and a buffer (120) which are connected downstream the mixer (100) and upstream the first filter (205), of the controlled switch (225) and level comparator (210).

5. The demodulation phase-locked loop of any of claims 1 to 4, characterized in that the first filter (205) is a filter including a resistor and a capacitor.

6. The demodulation phase-locked loop of claim 5, characterized in that it includes a means for decreasing the value of the resistance of the first filter (205) when the switch (225) is in its first position.

7. A satellite receiver characterized in that it includes a demodulation phase-locked loop according to any of claims 1 to 6.

8. A radio system characterized in that it includes a demodulation phase-locked loop according to any of claims 1 to 6.

9. A television system characterized in that it includes demodulation phase-locked loop according to any of claims 1 to 6.

## Patentansprüche

1. Eine Demodulations-Nachlaufsynchronisationsschaltung (phase-locked loop)(PLL) mit einem, mit einem gesteuerten Oszillator (230) verbundenen Mischer (100), dadurch gekennzeichnet, daß folgendes vorgesehen ist:

    der gesteuerte Oszillator (230) besitzt einen, eine niedrige Verstärkung aufweisenden Steuereingang (Steuereingangsgröße) (L), einen, eine hohe Verstärkung aufweisenden Steuereingang (H) und einen Ausgang (Ausgangsgröße) (240) verbunden mit einem ersten Eingang des Mischers (100);
    einen ersten Tiefpaßfilter (205), der mit seinem Eingang mit dem Ausgang (245) des Mischers (100) verbunden ;
    einen Pegelkomparator (210), der einen Ausgang (260) liefert, der dann aktiv ist, wenn die Signalpegel an dem Eingang (245) und dem Ausgang (250) des ersten Filters (205) hinreichend konvergiert haben;
    ein Frequenzkomparator (220), der eine Ausgang (255) vorsieht, der dann aktiv ist, wenn die Signalfrequenzen ($f_{VCO}$, $f_{IN}$) an den ersten und zweiten Eingängen (240, 235) des Mischers (100) hinreichend konvergiert haben;
    ein gesteuerter Schalter (225) mit einer ersten Position und mit einer zweiten Position, wobei in der ersten Position der Eingang und der Ausgang (245, 250) des ersten Filters (205) jeweils mit dem Hochverstärkungs(H)-Eingang bzw. dem Niedrigverstärkungs-Eingang (L) des gesteuerten Oszillators (230) verbunden sind, und wobei in der zweiten Position der Eingang und der Ausgang (245, 250) des ersten Filters (205) mit dem Niedrigverstärkungs(L)-Eingang bzw. dem Hochverstärkungs(H)-Eingang des Oszillators verbunden sind; und

Steuermittel (215) gekuppelt mit dem Pegelkomparator und dem Frequenzkomparator zur Auswahl der ersten Position des Schalters (225) dann, wenn die Frequenzen des Signals an den ersten und zweiten Eingängen (240, 235) des Mischers (100) nicht hinreichend konvergiert haben, und Auswahl der zweiten Position des Schalters (225) dann, wenn die Frequenzen des Signals an den ersten und zweiten Eingängen (240, 235) des Mischers (100) und die Pegel des Signals an dem Eingang und dem Ausgang (245, 250) des ersten Filters (205) hinreichend konvergiert haben.

2. Demodulations-Nachlaufsynchronisationsschaltung (PLL) nach Anspruch 1, dadurch gekennzeichnet, daß der gesteuerte Oszillator (230) einen stromgesteuerten Oszillator (300) aufweist und erste und zweite spannungsgesteuerte Stromquellen (305, 310), die Steuereingänge besitzen, die den Hochverstärkungs- bzw. Niederverstärkungs(H, L)-Eingängen des gesteuerten Oszillators (230) entsprechen, um die Frequenz des stromgesteuerten Oszillators (300) zu steuern.

3. Demodulations-Nachlaufsynchronisationsschaltung (PLL) nach Anspruch 2, dadurch gekennzeichnet, daß die zweite spannungsgesteuerte Stromquelle (310) sehr lineare Charakteristika bzw. Kennlinien besitzt.

4. Demodulations-Nachlaufsynchronisationsschaltung (PLL) nach einem der Ansprüche 1 bis 3 , dadurch gekennzeichnet, daß sie einen zweiten Tiefpaßfilter (110) und einen Puffer (120) aufweist, die stromabwärts gegenüber dem Mischer (100) und stromaufwärts gegenüber dem ersten Filter (205) des gesteuerten Schalters (225) und Pegelkomparators (210) angeschaltet sind.

5. Demodulations-Nachlaufsynchronisationsschaltung (PLL) nach einem der Ansprüche 1 bis 4, dadurch gekennzeichnet, daß der erste Filter (205) ein einen Widerstand und einen Kondensator aufweisender Filter ist.

6. Demodulations-Nachlaufsynchronisationsschaltung (PLL) nach Anspruch 5, dadurch gekennzeichnet, daß die Schaltung Mittel aufweist zur Verringerung des Widerstandswerts des ersten Filters (205), dann wenn der Schalter (225) sich in seiner ersten Position befindet.

7. Satellitenempfänger, dadurch gekennzeichnet, daß er eine Nachlaufsynchronisationsschaltung (PLL) gemäß einem der Ansprüche 1 bis 6 aufweist.

8. Rundfunksystem, dadurch gekennzeichnet, daß es eine Demodulations-Nachlaufsynchronisationsschaltung (PLL) gemäß einem der Ansprüche 1 bis 6 aufweist.

9. Fernsehsystem, dadurch gekennzeichnet, daß es eine Demodulations-Nachlaufsynchronisationsschaltung (PLL) gemäß einem der Ansprüche 1 bis 6 aufweist.

EP 0 722 215 B1

Fig 1

Fig 2

Fig 3

10

Fig 4A

Fig 4B

Fig 5A

$$\frac{dI_D}{dV_D} = \frac{-1}{R8}$$

Fig 5B

Fig 6

Fig 7A

$V_{REF3}$

Fig 7B

220

235   1000   1010   VIN   1020   1030

fIN   1040   1050   VOUT   INTEGRATEUR NUMERIQUE

fVCO   1060   255

240

VREF4

Fig 8A

SW1   1110

265

Fig 9A

1110

ΔV

265

Fig 9B

14

Fig 8B

Fig 8C

Fig 8D